# EUROPEAN PATENT APPLICATION

(11) **EP 0 546 678 A1**
(43) Date of publication of application: **16.06.1993**
(21) Application number: 92310091.1
(22) Date of filing: 04.11.1992
(51) Int. Cl.: G01R 31/32, H01H 33/04

(54) **Synthetic test circuits for short-circuit testing of high-voltage alternating current circuit-breakers, and triggered spark gaps for use in such circuits**

(30) Priority: 13.12.1991 GB 9126508
(71) Applicant: GEC ALSTHOM LIMITED, Rugby, Warwickshire CV21 1TB (GB)
(72) Inventor: Bliss, Charles Alan, Shrewsbury, SY3 8SB (GB)
(74) Representative: Keppler, William Patrick

(57) **Abstract**

A triggered spark gap (TSG1) is provided for use in the high current circuit of a synthetic test circuit for short-circuit testing of high voltage alternating current power transission circuit-breakers. A sealed vessel (I) filled in use with electro-negative gas has two inwardly projecting tubular contacts (21, 22) forming a spark gap between carbon nozzles (211, 221) at their inner ends with a trigger electrode (23) in one of the nozzles (221). A pressure chamber to contain an arc initiated by the trigger electrode (23) includes a movable cylinder (30) closed at one end on to one of the contacts (21) and closed on to the other contact (22) via a fixed piston (40), the cylinder (30) carrying a movable contact (50). Arc generated gas pressure expands the pressure chamber so that the movable contact (50) rapidly bridges the tubular contacts (21, 22) to short out the arc.

## Description

This invention relates to synthetic test circuits for short-circuit testing of high-voltage alternating current circuit-breakers, and to triggered spark gaps for use in such circuits.

Synthetic short-circuit testing of high-voltage alternating current circuit-breakers is the subject of IEC Publication 427 (1989).

These circuit-breakers are for use in protection and control of electrical power transmission systems. The system voltage is in the range approximately 100kV to 1000kV, and a circuit-breaker for use in a British 420kV three phase system would typically need to carry for each phase a normal current up to 4000A and a short-circuit current of up to 63kA at a power frequency of 50Hz. The normal current is carried substantially in phase with the voltage for each phase of the system to a substantially resistive load.

If a short-circuit fault condition occurs in a transmission system as described above, then transformers in the transmission system provide a substantially inductive circuit in which the short-circuit current lags the system voltage by substantially 90 degrees. Circuit breakers have an interrupter unit or a group of interrupter units in series for each pole (phase) of the transmission system, each unit providing a contact gap which is opened by a moving contact to break the short-circuit and then withstand the system voltage or the appropriate fraction of the system voltage where there is a group of gaps in series. As the or each contact gap is opened an arc will be established which will maintain a reduced alternating voltage across the gap and carry the alternating short-circuit current. When the alternating short-circuit current next goes through zero the arc should extinguish to break the short-circuit. At this time the leading alternating system voltage will be substantially at its peak and the change from the small arc voltage across the contact gap to this full or fraction peak voltage will increase this full or fraction peak voltage by a transient oscillation. The or each open contact gap must withstand this so-called transient recovery voltage so that the arc is not re-established and the short-circuit remains broken.

Testing a circuit-breaker interrupter unit for its ability reliably to break a system short-circuit requires the application to that interrupter unit of both the rated short-circuit current and the transient recovery voltage. Present designs of high voltage transmission circuit-breakers commonly have a single interrupter unit per phase up to a system voltage of 245 KV (with rated short-circuit current for example 40 KA) and two interrupter units per phase up to a system voltage of 525 KV (with rated short-circuit current for example 63 KA). For these circuit-breakers it is not possible for test apparatus to have a single high enough power source to provide both the short-circuit current and the transient recovery voltage. The known solution to this problem is to adopt so-called synthetic testing. IEC publication 56 (1987) 6.102.4 defines a synthetic test as "a test in which all of the current, or a major portion of it, is obtained from one source (power-frequency current circuit) and in which the transient recovery voltage is obtained wholly or in part from one or more separate sources (voltage circuits), this voltage corresponding to the rated voltage of the tested circuit-breaker. The voltage of the power-frequency current source may be a fraction of that of the voltage circuit." As indicated in the previous paragraph the voltage across a closed interrupter contact gap carrying short-circuit current is substantially zero and as the gap opens there is a reduced voltage maintained by the arc. Thus the power source in a synthetic test circuit which is arranged to provide the high (rated short-circuit) alternating current at the power-frequency of the transmission system to the interrupter unit in a breaking test need only have this reduced voltage and typically has one tenth of the system voltage. It has been shown that the short-circuit breaking performance of an interrupter unit when the contact gap has been opened is significantly affected by the rate of change of current as it next passes through zero, and an equivalent performance is obtained if this same rate of change of current is provided by the transient recovery voltage source in a synthetic test circuit providing a reduced current (typically one tenth of the rated short-circuit current) at a correspondingly high-frequency (typically ten times the power-frequency of the transmission system).

The transient recovery voltage is provided by the discharge of a capacitor which is initiated by a spark gap which is triggered at the appropriate moment, the separate high (short-circuit) current source being disconnected from the interrupter unit under test immediately prior to this moment. This triggered spark gap in the transient recovery voltage circuit has to carry only the reduced current mentioned and for only the transient time (less than half a cycle of the power frequency) and it has not been difficult to provide such a device which can be used reliably and repeatedly in the synthetic test circuit.

In the above we have described what happens as a circuit-breaker interrupter unit breaks a transmission system short-circuit and the characteristics of a synthetic test circuit to test the unit for this short-circuit breaking. Another situation which the circuit-breaker may meet in service is closing onto a pre-existing short-circuit fault condition in the transmission system. In this case, as the contact gap of each interrupter unit of the circuit-breaker is closing an arc will commence typically when the system voltage is substantially at its peak. This so-called pre-arc will carry the alternating short-circuit current and will maintain a reduced alternating voltage across the gap until the gap is fully closed, the duration of the pre-arc being called the pre-arcing time. The design of a particular interrupter unit will determine its pre-arcing time in operation in the transmission system; the contact gap length at which the pre-arc commences will depend on the design of the gap contacts and in particular will depend on the system voltage and the fraction of that system voltage applied to the gap, and the pre-arc will then persist for a time dependent on the closing speed of the gap.

An interrupter unit must be able reliably to close on to a pre-existing short-circuit fault condition in the transmission system without any adverse effect on the ability of that interrupter unit to clear the fault on the subsequent opening operation. Full short-circuit testing of an interrupter unit (for example as defined in IEC Publication 56 (1987) ) requires it to undergo a series of tests in which a closing operation is immediately followed by an opening operation. If this close-open operation is performed on the interrupter unit in the synthetic test circuit as described above, then during the closing operation the contact gap of the interrupter unit will be subjected to only the reduced voltage of the high current source and so the pre-arc will commence later than it would when subjected to the voltage impressed across it in operation in the transmission system. It is considered that for a contact gap which has a pre-arcing time in operation in the transmission system, greater than 1/_{M} seconds (3.2 ms for 50 Hz), (as specified by IEC Publication 427 (1989), then the shorter pre-arcing time provided by the synthetic test circuit described above will not sufficiently stress the interrupter unit for a satisfactory test. The trend in design of high voltage transmission circuit-breakers is to reduce the number of interrupter units per phase for increasingly high system voltages, for example we envisage a circuit-breaker having a single interrupter unit per phase for a system voltage of 420 KV with a rated short-circuit current of 63KA. Particularly as the number of interrupter units per phase is reduced, the consequent increase in the voltage impressed across each interrupter unit makes it more likely that the resulting increased pre-arcing time will be greater than II", seconds.

A known proposal for modification of the above described synthetic test circuit in order to test an interrupter unit with a correct pre-arcing time which may be greater than 1/_{M} seconds is to provide the test circuit with an additional, separate, power source (high-voltage circuit) which applies the correct system voltage at the power-frequency to the interrupter contact gap in the closing operation and thus causes the pre-arc to commence at the correct moment. Since no current is carried by the contact gap before pre-arc, this high-voltage circuit may have a weak power source with a low current. The high (short-circuit) current source must be protected from this applied high voltage before the pre-arc commences in the interrupter unit, and then immediately after pre-arc commences (which reduces the voltage across the contact gap) the high current must be supplied to the interrupter unit. The known proposal to meet this requirement is to provide a spark gap in the high current circuit which is triggered in response to detection of current in the high-voltage circuit.

The just-mentioned triggered spark gap in the high current circuit of the synthetic test circuit has to carry the high (short-circuit) current and furthermore this high current has to be supplied to the interrupter unit for substantially the remainder of the close-open operation of that unit (typically about six cycles of the power frequency). To avoid excess wear, means must therefore be provided to short out the arc of the triggered spark gap as soon as possible after it has been triggered (ideally within half a cycle of the power frequency) and then carry the high current until it is eventually disconnected prior to application of the transient recovery voltage.

In a report entitled "Three phase synthetic make test circuit" by G.C. Damstra KEMA presented at the Colloquium of CIGRE SC13 Sarajevo, May 1989, both a particular design of triggered spark gap for use in the high current circuit and also particular means for shorting out the arc of that triggered spark gap and then carrying the high current are proposed. The particular triggered spark gap has an insulating cylindrical vessel which in use is filled with 2 bar nitrogen. Two tubular contacts project towards each other from opposite ends of the vessel with carbon nozzle electrodes at their inner ends. One of the carbon electrodes holds a trigger electrode for providing a plasma jet to initiate an arc across the gap between the two carbon electrodes. A pressure chamber surrounds the inner ends of the tubular contacts to contain the arc, and holes are provided in the tubular contacts to allow arc pressurised gas to leak from the pressure chamber into the surrounding vessel. The gap must be long enough so that at the basic gas pressure it will withstand the voltage of the high voltage power-frequency circuit in the synthetic test circuit, and it must be triggered by the plasma jet electrode at the reduced voltage of the high current circuit of the synthetic test circuit, this reduced voltage being across the gap immediately after pre-arc commences in the interrupter unit under test. The time from pre-arc commencement in the interrupter unit to establishment of an arc in the triggered spark gap will be approximately 100 usec. The particular means for shorting out the arc of the triggered spark gap and then carrying the high current has a moving contact switch which is connected in parallel with the triggered spark gap and a control circuit to operate the switch which is responsive to the same current detector in the high voltage circuit which initiates triggering of the triggered spark gap. This switch has an insulating cylindrical vessel containing 3 bar SF₆ gas. A fixed contact and a moving contact are separated in the unoperated condition by a gap able to withstand the voltage of the high voltage power frequency circuit in the synthetic test circuit. An electrodynamic latch is provided to release the moving contact which is driven at high speed by compressed air moving a piston in a cylinder. The fixed contact is provided with a gas spring damper mechanism to obtain practically bounce free contact with the moving contact. The closing time for the switch is 6.5 usec. This moving contact switch is, as just described, a device having considerable complexity in order to achieve its required performance and there is therefore a problem concerning its reliability. If for any reason involving either this moving contact switch itself or its control responsive to pre-arc detection, it fails to close when required then the short-circuit current carrying arc will continue in the triggered spark gap. If this failure occurs, then the triggered spark gap will be severely damaged by the continuing arc and probably rendered useless by such a failure in only one test operation.

An object of the invention is to provide a synthetic test circuit with a triggered spark gap for the high current circuit avoiding excess wear of that spark gap in an alternative manner to that proposed by Damstra.

According to the present invention there is provided a synthetic test circuit for short-circuit testing of high-voltage alternating current electrical power transmission system circuit-breakers, said test circuit including
(A) a high current circuit arranged to apply high (system short-circuit) current at system power-frequency and voltage reduced with respect to the system voltage to a circuit-breaker interrupter unit contact gap in a closing operation and in a following opening operation of the interrupter unit,
(B) a first voltage circuit arranged to apply the system voltage at the system power-frequency and current reduced with respect to the system short-circuit current to said contact gap in a closing operation of the interrupter unit; and
(C) a second voltage circuit arranged to apply transient recovery voltage higher than the system voltage at a frequency higher than the system power-frequency and current reduced with respect to the system short-circuit current to said contact gap in an opening operation of the interrupter unit;

wherein said high current circuit includes
(a) a triggered spark gap able to withstand the applied voltage of said first voltage circuit and arranged to be triggered to enable the high current circuit to apply said high current to said interrrupter unit contact gap responsive to commencement of pre-arc in this contact gap in a said closing operation, said triggered spark gap including
   (i) an insulating cylindrical vessel able to be filled in use with electro-negative gas at predetermined pressure,
   (ii) two tubular contacts which project towards each other from opposite ends of the vessel with a spark gap between carbon nozzle electrodes at their inner ends,
   (iii) a trigger electrode in one of the carbon nozzle electrodes for initiating an arc across said spark gap, and
   (iv) a pressure chamber surrounding the inner ends of the tubular contacts to contain said arc, holes being provided in the tubular contacts to allow arc pressurised gas to leak from the pressure chamber into the surrounding vessel,

   and wherein said high current circuit also includes
(b) means adapted to short out the arc of said triggered spark gap and to enable the high current circuit to continue to apply said high current to said interrupter unit contact gap for substantially the remainder of a closing and subsequent opening operation of that unit,

characterised in that said pressure chamber in said triggered spark gap includes a cylinder and a piston, the cylinder having a portion at one end thereof which closes on to one of the tubular contacts and the cylinder being closed on to the other tubular contact via the piston, in that said means adapted to short out the arc of said triggered spark gap includes a movable contact carried by the pressure chamber, in that means are provided for effecting relative movement of the cylinder and piston before operation of the trigger electrode to an initial position in which the pressure chamber has a predetermined volume and said movable contact does not intrude into the spark gap, and in that the configuration of the cylinder, piston and movable contact and said predetermined volume are such that arc generated gas pressure which results from triggering the spark gap expands the pressure chamber to the extent that the movable contact bridges the tubular contacts to short out the arc across the spark gap.

According to the invention there is also provided a triggered spark gap for use in a synthetic test circuit, the triggered spark gap and the circuit in which it is to be used being as defined in the previous paragraph.

The triggered spark gap as defined in the penultimate paragraph, which is the essential element of the present invention, obviates the need for a parallel connected switch and a control circuit to operate that switch to short out the triggered arc. In our triggered spark gap the gas pressure generated by the arc itself causes the moving contact quickly to short out the arc and thereafter to carry the high (short-circuit) current. Rapid shorting of the spark gap arc by 'self-servo' operation inherent in the triggered spark gap device itself ensures that the arc cannot continue and cause damage, and this self protection enables the device to remain in place within apparatus incorporating the synthetic test circuit for reliable repeated use in operations of the test circuit.

An example of a synthetic test circuit with a 'self-servo' operating triggered spark gap, according to the invention, will now be described with reference to the accompanying drawings, in which:
Figure I shows, in schematic form, the current and voltage circuits provided in a synthetic test circuit arranged for close-open short-circuit testing of an interrupter unit incorporated in a high-voltage transmission circuit-breaker, the test circuit including a high current circuit with a 'self-servo' operating triggered spark gap,
Figure 2 shows a timing diagram of short-circuit current through the interrupter unit in operation of the test circuit of Figure I in relation to the closed and open condition of the contact gap of the interrupter unit, and
Figure 3 shows the 'self-servo' operating triggered spark gap.

Referring now to Figures I and 2, the switch TB represents a contact gap and moving contact for closing and opening the gap, as is provided in an interrupter unit in a high-voltage alternating current circuit-breaker for use in an electrical power transmission system. The complete circuit-breaker will have one or a group of interrupter units in series, typically in a common gas-insulated metal enclosure, for each phase of a three phase transmission system. For example, the circuit-breaker may have two interrupter units per phase for a British 420 KV system voltage with a normal current of 4000A and a rated short-circuit current of 50KA. Figure I shows current and voltage circuits provided for short-circuit testing of one interrupter unit; a complete test equipment for a circuit-breaker will have a combination of a number of these current and voltage circuits.

In the test circuit of Figure I a high current circuit includes a power source S1 which is arranged to apply high (system short-circuit) current, for example 50KA, at system power-frequency (for example 50 Hz) and voltage reduced with respect to the system voltage to the contact gap of the interrupter unit TB under test in a closing operation and in a following opening operation of the interrupter unit. The reduced voltage of the source S1 may be typically one tenth of the system voltage. This power-frequency high current is applied to the unit TB via a master circuit-breaker MB, an auxiliary circuit-breaker AB and a triggered spark gap TSG1. A voltage circuit U1 is arranged to apply the system voltage, for example 420 KVIV3, at the system power-frequency and current reduced with respect to the system short-circuit current to the contact gap of the interrupter unit TB under test in a closing operation of the interrupter unit. The voltage circuit U1 may have a weak power source S2 whose voltage is stepped up by a transformer. The reduced current applied by the voltage circuit U1 may typically be one tenth of the short-circuit current, for example approximately 5KA. The power-frequency high (short-circuit) current provided by the high current circuit is arranged to lag both the reduced voltage in the high current circuit and the power-frequency (system) voltage provided by the voltage circuit U1 by 90 degrees to simulate a short-circuit fault condition in a transmission system. A current detector D in the voltage circuit U1 is connected to the trigger electrode of the triggered spark gap TSG1.

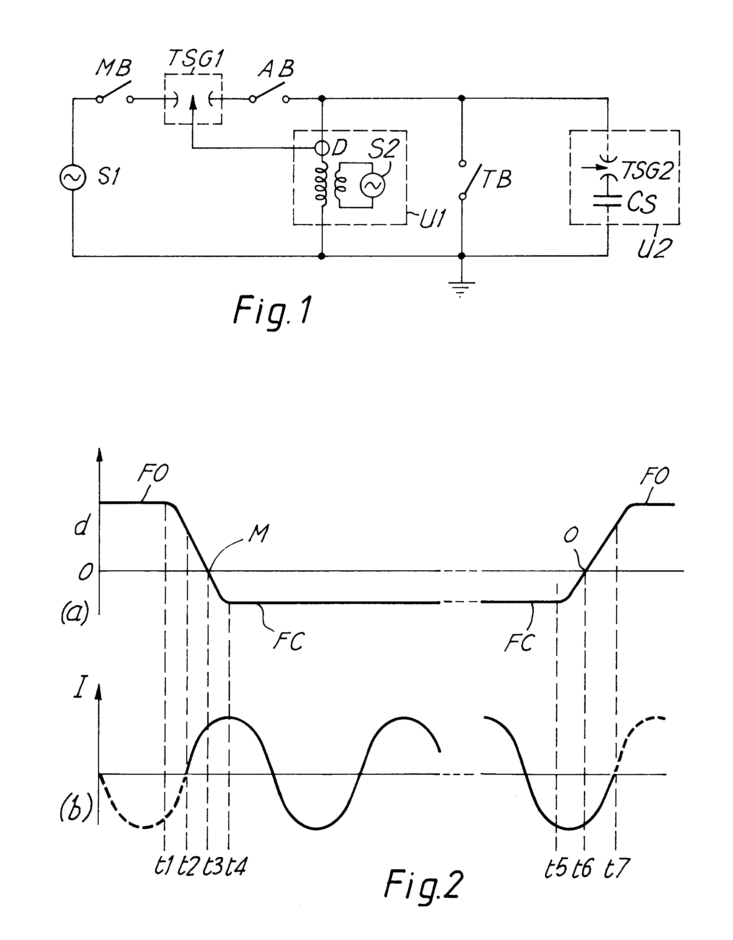

A close-open test of the interrupter unit TB commences with its moving contact in position such that before time t1 shown in Figure 2 the contact gap is fully open (FO) and has a maximum effective distance d. At this time the power-frequency system voltage is applied to the unit TB by the voltage circuit U1. This voltage is withstood by the fully open unit TB and no current flows in the voltage circuit U1. The master circuit-breaker MB and the auxiliary circuit-breaker AB have been closed but the high current I is disconnected from the unit TB by the triggered spark gap TSG1 which also withstands the applied voltage of the voltage circuit U1.

The interrupter unit TB is then operated to close the contact gap and at time t2 the contact gap breaks down and an arc (the pre-arc) commences across that gap. The pre-arc will usually commence when the applied voltage of the voltage circuit U1 is substantially at its peak resulting in a symmetrical current. The pre-arc causes the applied voltage across the contact gap to collapse and current to flow in the voltage circuit U1. In response to detection of that current in the voltage circuit U1 by the detector D the triggered spark gap TSG1 is triggered to enable the high current circuit to apply the high current I to the contact gap of the interrupter unit TB. There will be a short delay time (up to approximately 100 u, sec) from commencement of the pre-arc to application of the high current I via the triggered spark gap TSG1, whereas in operation of the interrupter unit TB in a transmission system the pre-arc will immediately carry the high (short-circuit) current. A capacitor discharge circuit (not shown) may be included which, responsive to the detector D, provides an initial transient making current (ITMC) to simulate the action of the transmission system during this short delay time.

The pre-arc in the interrupter unit TB will continue until it is shorted out by its moving contact reducing the contact gap to zero (making M) at time t3, and the closing operation of the interrupter unit will be completed when its moving contact reaches its fully closed (FC) latched position at time t4.

Means (not shown) are provided to detect that high (short-circuit) current I is being carried by the interrupter unit TB and, simulating its operation in a transmission system, commence an opening operation of the interrupter unit TB at time t5 after about 5 cycles (100 ms for a power-frequency of 50 Hz). In the opening operation the moving contact of the unit TB opens its contact gap (0) at time t6 and an arc is established across the gap which continues to carry the alternating high current I. When the alternating current I next goes through zero at time t7 the arc should extinguish to break the short-circuit, after which the moving contact reaches the fully open (FO) position. At this time the substantially peak leading voltage of the high current circuit will only be that of the reduced voltage (with respect to the system voltage) of that circuit. In order to test the short-circuit breaking performance of the interrupter unit TB in a simulation of the transmission system a second voltage circuit U2 is provided to apply transient recovery voltage with respect to the system voltage (which is for example 420 KV/.j 3) at a frequency higher than the system power-frequency (typically ten times higher at 500 Hz) and current correspondingly reduced with respect to the system short-circuit current (typically 5KA) to the contact gap of the unit TB at the time t7. Immediately before the time t7 the high current circuit is disconnected from the unit TB by opening the auxiliary circuit-breaker AB and then the voltage circuit U2 applies transient recovery voltage to the unit TB by discharge of a capacitor Cₛ which is initiated by triggering a triggered spark gap TSG2. This triggered spark gap TSG2 has to carry only the reduced current and for only the transient time (less than half a cycle of the power-frequency) and a single such device can therefore be used repeatedly in the test circuit without difficulty.

The high current circuit thus has to supply the high (short-circuit) current to the interrupter unit TB between the times t2 and t7 (about six cycles of the power-frequency). To avoid excess wear of the triggered spark gap TSG1, means must therefore be provided to short out the arc of the triggered spark gap TSG1 as soon as possible after it has been triggered and then carry the high current for the required time.

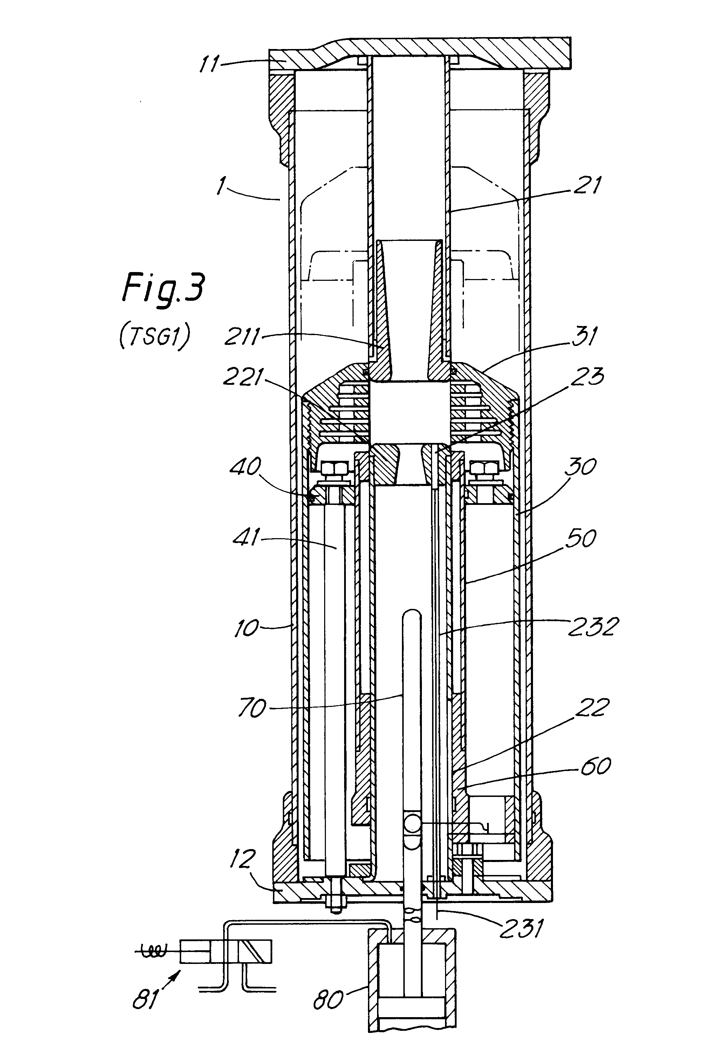

Before describing the triggered spark gap TSG1 with reference to Figure 3, possible variations of the test circuit shown in Figure I may be mentioned as follows. Instead of the voltage circuit U1 being connected in parallel with the high current circuit across the interrupter unit TB, as shown in Figure 1, this circuit U1 may be connected across the triggered spark gap TSG1 and in series with the power source S1 of the high current circuit. Also, instead of the voltage circuit U2 being connected in parallel with the high current circuit across the interrupter unit TB as shown in Figure 1, this circuit U2 may be connected across the auxiliary circuit-breaker AB and in series with the power source S1 of the high current circuit.

Referring now to Figure 3 there is shown a triggered spark gap TSG1 in which rapid shorting of the spark gap arc is achieved by 'self-servo' operation inherent in the triggered spark gap device itself. An insulating cylindrical vessel 1 has a circular cylindrical tube 10 of electrically insulating material (for example terylene epoxy) closed at its upper and lower (as shown in Figure 3) ends by respective metal plates II, 12 from which are also formed the two spark gap electrical terminals of the device. The vessel 1 may typically be about 1000 mm in length and 300 mm in diameter. A valve (not shown) is provided in one of the end plates II, 12 by means of which the vessel 1 is able to be filled in use with electro-negative gas at predetermined pressure (for example SF₆ gas at I to 2 atmospheres as will be discussed later). Two tubular metal contacts are provided, each mounted on one of the end plates II, 12 projecting towards each other from opposite ends of the vessel 1. Each tubular contact 21, 22 has a graphite nozzle 211, 221 pressed into its inner end and the axial gap between the nozzles 211, 221 is a spark gap, which may be for example about 60 mm in length. A trigger electrode 23 in the form of a plasma gun for initiating an arc across the spark gap is held in the nozzle electrode 221 and an electrical lead 231 from the trigger electrode 23 is located in an insulating tube 232 and is fed through the end plate 12 to provide the trigger electrical terminal of the device.

A pressure chamber surrounds the inner ends of the tubular contacts 21, 22 to contain an arc initiated by the trigger electrode 23, holes (not shown) being provided in the tubular contacts 21, 22 near their outer ends to allow arc pressurised gas to leak from the pressure chamber into the surrounding vessel 1. The pressure chamber includes a movable cylinder 30 and a fixed piston 40 concentric with the tubular contacts 21, 22. The cylinder 30 has a portion 31 at one end which closes on to the tubular contact 21, and the cylinder 30 is closed on to the tubular contact 22 via the piston 40 and a movable contact 50. The movable contact 50 includes a cylindrical assembly of spring-loaded contact fingers which is carried by the end of the cylinder 30 near the end plate 12 via a bridging member 60. The fixed piston 40 is held by three rods 41 attached to the end plate 12. The composite assembly of the cylinder 30, movable contact 50 and bridging member 60 is joined to an operating rod 70 axially located within the tubular contact 22 via a pin (not shown) passing through a slot in the tubular contact 22 between the member 60 and the rod 70. The operating rod 70 passes through the end plate 12 to an air engine 80. The rod 70 and engine 80 are provided to enable the cylinder 30 to be moved (downwards as shown in Figure 3) relative to the piston 40 before operation of the trigger electrode 23 to an initial position, which is that shown in Figure 3, in which the pressure chamber has a predetermined volume and the movable contact 50 does not intrude into the spark gap. The configuration of the cylinder 30, piston 40 and movable contact 50 and the predetermined initial volume of the pressure chamber are such that arc generated gas pressure which results from triggering the spark gap expands the pressure chamber to the extent that the movable contact 50 bridges the tubular contacts to short out the arc across the spark gap. When the arc is first triggered there is a rise in gas pressure within the pressure chamber and gas flows out through the carbon nozzles 211, 221 and the holes in the tubular electrodes 21, 22. When the gas flow through the nozzles 211, 221 reaches its limiting sonic velocity the pressure within the pressure chamber will rise very rapidly and exert a force sufficient to move the cylinder 30 and movable contact 50. The movable contact 50 will short out the arc within half a cycle of the applied power-frequency (10 ms at 50 Hz) after it has been triggered. The dotted outline in Figure 3 shows the rest position of the cylinder portion 31 and the movable contact 50 when the contact 50 has bridged the spark gap. This rest position is determined by the amount of movement (in the upward direction shown in Figure 3) permitted by the air engine 80. The spring-loading of the fingers of the contact 50 keeps it in this bridging position so that continues to carry current for the required time. In use in test apparatus the vessel 1 may be vertically upright as shown in Figure 3 or upside down with respect to Figure 3 or horizontal.

The air engine 80 has a solenoid operated valve 81 which temporarily disconnects it from atmospheric pressure and connects it to high pressure to effect movement of the rod 70 to the initial position shown. Different means for moving the cylinder 30 and movable content 50 to their initial position could be provided, for example a spring or a manual lever.

Some criteria for the triggered spark gap described above with reference to Figure 3 are as follows. It is intended that the outside of the vessel 1 be exposed to air at atmospheric pressure. The pressure of the electro-negative gas (for example SF6) inside the vessel 1 should therefore not be too high in order to avoid subjecting the vessel 1 to undue stress, and a gas pressure of about 1 or 2 atmospheres within the vessel will satisfy this requirement. For a predetermined gas pressure within the vessel 1, the length of the spark gap between the carbon nozzles 211, 221 must be sufficient to withstand the voltage applied to the spark gap terminals before it is triggered while at the same time being short enough to facilitate rapid bridging by the movable contact 50 when it is triggered. Having determined a particular spark gap length, the same triggered spark gap may then be used to withstand different applied voltages appropriate to different circuit-breakers being tested by appropriately varying the gas pressure within the vessel 1. The comparatively low gas pressure within the vessel 1 facilitates triggering of the spark gap when required. For a given spark gap length the volume of the pressure chamber in the initial position should be minimised to facilitate a rapid rise in gas pressure and hence a short delay before movement of the cylinder 30 and contact 50 after the spark gap is triggered. To this end, the configuration of the cylinder 30 and the piston 40 is such that in the initial position (as shown in Figure 3) the cylinder 30 closes on to each tubular contact 21, 22 adjacent its inner end; and furthermore the portion 31 of the cylinder 30 which closes on to the tubular contact 21 has an inner diameter substantially equal to the outer diameter of that contact 21 for an axial length equal to a major portion of the length of the spark gap. It may be mentioned here that the portion 31 may be made of PTFE and the labrinth design of passages through the portion 31 as shown helps to prevent undue burning of the cylinder 30 by the arc as it moves. Once the contact 50 starts moving with cylinder 30 it should bridge the contacts 21, 22 as soon as possible, and this is facilitated by one end of the contact 50 being adjacent the spark gap in its initial position as shown in Figure 3.

We envisage that arrangements of a cylinder and piston forming a pressure chamber and carrying a movable contact different to that described above with reference to Figure 3 may be provided, for example the pressure chamber could have a fixed cylinder and a movable piston.

In order to provide the component parts for one example of a triggered spark gap according to the invention, as is shown in Figure 3, we have taken and modified component parts of one of our known high voltage alternating current circuit-breaker interrupter units. That interrupter unit has a contact gap between carbon nozzles set in tubular contacts which project axially inwards from the ends of a cylindrical vessel. In this case the vessel is in a metal enclosure, the outer end of each of the tubular contacts is open and SF₆ gas fills the vessel and the enclosure. The interrupter has a piston, cylinder with end piece, movable contact, bridging piece and rod similar to those shown in Figure 3 but their configuration, arrangement and operation are different. That is to say that in the interrupter unit the rod is actuated by external (hydraulic) means between a first position where the movable contact bridges the contact gap and a second position where the movable contact rests on the open ended tubular contact and the circuit is broken. During an opening stroke an arc is formed across the contact gap and the end portion of the cylinder while sealed to the closed end tubular contact prevents gas flowing out of the cylinder and generates a gas pressure differential; the cylinder acts as a blast cylinder to contain the arc and the gas pressure helps to extinguish that arc. At the completion of the opening stroke the end portion of the cylinder has moved across the contact gap and rests on the open-ended tubular contact.

## Claims

1. A synthetic test circuit for short-circuit testing of high-voltage alternating current electrical power transmission system circuit-breakers, said test circuit including:
(A) a high current circuit arranged to apply high (system short-circuit) current at system power-frequency and voltage reduced with respect to the system voltage to a circuit-breaker interrupter unit contact gap in a closing operation and in a following opening operation of the interrupter unit,
(B) a first voltage circuit arranged to apply the system voltage at the system power-frequency and current reduced with respect to the system short-circuit current to said contact gap in a closing operation of the interrupter unit; and
(C) a second voltage circuit arranged to apply transient recovery voltage higher than the system voltage at a frequency higher than the system power-frequency and current reduced with respect to the system short-circuit current to said contact gap in an opening operation of the interrupter unit;
wherein said high current circuit includes
(a) a triggered spark gap able to withstand the applied voltage of said first voltage circuit and arranged to be triggered to enable the high current circuit to apply said high current to said interrupter unit contact gap responsive to commencement of pre-arc in this contact gap in a said closing operation, said triggered spark gap including
(i) an insulating cylindrical vessel able to be filled in use with electro-negative gas at predetermined pressure,
(ii) two tubular contacts which project towards each other from opposite ends of the vessel with a spark gap between carbon nozzle electrodes at their inner ends,
(iii)a trigger electrode in one of the carbon nozzle electrodes for initiating an arc across said spark gap, and
(iv) a pressure chamber surrounding the inner ends of the tubular contacts to contain said arc, holes being provided in the tubular contacts to allow arc pressurised gas to leak from the pressure chamber into the surrounding vessel,
and wherein said high current circuit also includes
(b) means adapted to short out the arc of said triggered spark gap and to enable the high current circuit to continue to apply said high current to said interrupter unit contact gap for substantially the remainder of a closing and subsequent opening operation of that unit,
characterised in that said pressure chamber in said triggered spark gap includes a cylinder and a piston, the cylinder having a portion at one end thereof which closes on to one of the tubular contacts and the cylinder being closed on to the other tubular contact via the piston, in that said means adapted to short out the arc of said triggered spark gap includes a movable contact carried by the pressure chamber, in that means are provided for effecting relative movement of the cylinder and piston before operation of the trigger electrode to an initial position in which the pressure chamber has a predetermined volume and said movable contact does not intrude into the spark gap, and in that the configuration of the cylinder, piston and movable contact and said predetermined volume are such that arc generated gas pressure which results from triggering the spark gap expands the pressure chamber to the extent that the movable contact bridges the tubular contacts to short out the arc across the spark gap.

2. A circuit including a triggered spark gap, as claimed in Claim 1, in which the piston is fixed and in which the movable contact is carried by the cylinder.

3. A circuit including a triggered spark gap, as claimed in Claim 2, in which the configuration of the cylinder and the piston is such that in said initial position the cylinder closes on to each tubular contact adjacent its inner end.

4. A circuit including a triggered spark gap, as claimed in Claim 3, in which the portion of the cylinder which closes on to said one of the tubular contacts has an inner diameter substantially equal to the outer diameter of that tubular contact for an axial length equal to a major portion of the length of the spark gap.

5. A circuit including a triggered spark gap as claimed in any preceding claim, in which one end of the movable contact is arranged to be adjacent the spark gap in said initial position.

6. A triggered spark gap for use in a synthetic test circuit, the triggered spark gap and the circuit in which it is to be used being as defined in any preceding claim.

7. A triggered spark gap substantially as herein described with reference to and as shown in the Figure 3 of the accompanying drawings.
